# EUROPEAN PATENT APPLICATION

(11) **EP 3 971 896 A1**
(43) Date of publication of application: **23.03.2022**
(21) Application number: 20196741.1
(22) Date of filing: 17.09.2020
(51) Int. Cl.: G11C 11/16, H01L 43/08

(54) **ANTIFERROMAGNETIC MEMORY DEVICE**

(71) Applicant: Universität Basel, 4001 Basel (CH); Helmholtz-Zentrum Dresden - Rossendorf e.V., 01328 Dresden (DE)
(72) Inventor: HEDRICH, Natascha, 4052 Basel (CH); WAGNER, Kai, 4053 Basel (CH); SHIELDS, Brendan J., 4057 Basel (CH); MALETINSKY, Patrick, 8006 Zürich (CH); PYLYPOVSKYI, Oleksandr V., 01328 Dresden (DE); KOSUB, Tobias, 01127 Dresden (DE); MAKAROV, Denys, 01109 Dresden (DE); SHEKA, Denys D., 03127 Kyiv (UA)
(74) Representative: Schulz Junghans Patentanwälte PartGmbB

(57) **Abstract**

The invention relates to an antiferromagnetic memory structure (1) configured for use in a non-transitory antiferromagnetic memory device (2), characterized in that the antiferromagnetic memory structure (1) comprises an antiferromagnetic memory body (10) comprising an antiferromagnetic compound, wherein on a first side (10-1) of the antiferromagnetic memory body (10), the antiferromagnetic memory body (10) comprises a plurality of separately arranged protrusions (30, 30-1, 30-2) protruding away from the first side (10-1) of the antiferromagnetic memory body (10), wherein each of the protrusions (30) comprises a memory unit (40) configured to store information.

## Description

The invention relates to an antiferromagnetic memory device that is configured and adapted to store, write and read information on a uniaxial antiferromagnetic memory body as well as a method for reading and writing the antiferromagnetic memory device.

Antiferromagnetic compounds have become interesting candidates for computer memory. Antiferromagnetic memory devices have the potential to overcome limitations of conventional memory devices that are based on magnetic or electronic semiconductor devices. These limitations are for example the sensitivity to external electromagnetic fields (perturbations) and high energy radiation that can cause complete data loss of the memory device. In contrast, antiferromagnetic memory devices are robust against external charge and magnetic field perturbations. This is because information may be stored in the orientation of the spins. Antiferromagnetic memories have the potential to be switched in the sub-ps time domain, i.e. writing can be performed at unprecedented speed. Antiferromagnetic devices are associated to the field of spintronics.

Recently it could be shown (Science, 5 Feb 2016, Vol 351 Issue 6273, Wadley et al. 2016, doi: 10.1126/science.aab1031) that electrical switching of antiferromagnetic compounds is possible, which opened up the possibility to efficiently read and write antiferromagnetic devices. It could be shown that reliable and ultra-fast switching of the antiferromagnetic device can be achieved and used for computer-based memories (Nature Communications,8:15434, Olejnik et al., 2016 doi: 10.1038/ncomms15434).

Further, magneto-electric switching has been demonstrated such that a purely antiferromagnetic random access memory (AF-MERAM) could be realized on a thin film antiferromagnetic memory device (Nature communications, Kosub et al, 2017, 8:13985 doi: 10.1038/ncomms13985).

The devices known in the art store single bits in a plurality of memory units or memory cells in which a single bit may be stored. Information is comprised in the orientation of the Neel vector in the memory unit. However, as within a single memory unit, the Neel vector typically exhibits a variety of particularly opposite orientations, the read-out and writing of information in a memory unit is based on a 'majority vote' method, i.e. by evaluating a net orientation of the Neel vector over the whole memory unit. The net orientation may be obtained detecting or obtaining a sum signal of all Neel vectors in the memory unit.

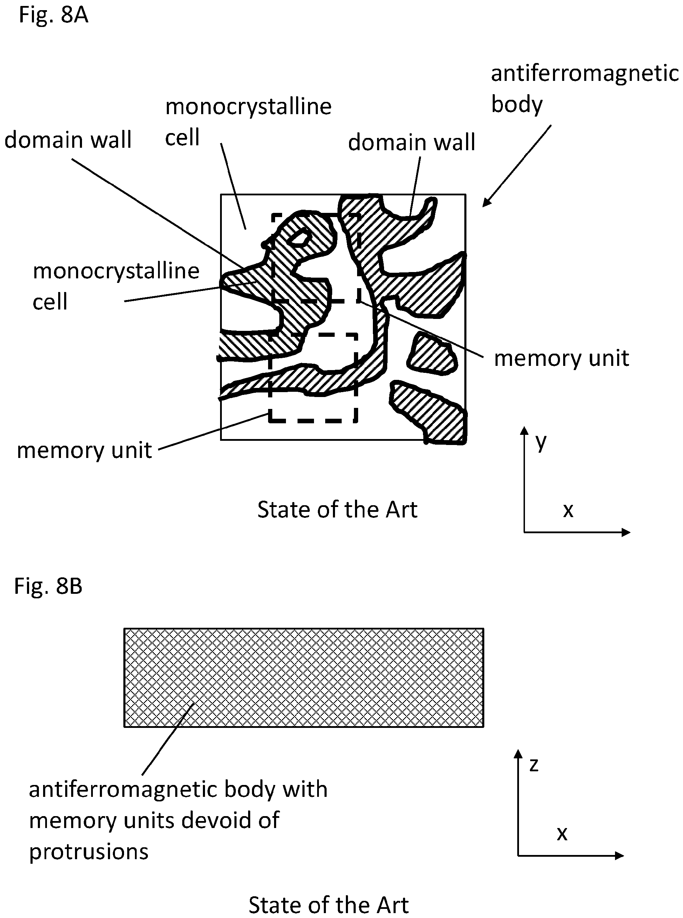

One reason that each memory unit typically comprises a plurality of Neel vectors oriented along different directions is that the memory devices are based on a thin film technology in which the antiferromagnetic layer of several have a thickness in the range of nanometers to microns. This in turn causes the antiferromagnetic compound to be assembled in a granular-like fashion. As a consequence, the antiferromagnetic layer exhibits a large number of domain walls that are crisscrossing and intersecting within a single memory unit enclosing small monocrystalline cells having the Neel vector oriented along one direction only (cf. Fig. 8). This structure of domain walls inside a single memory unit and the associated energy landscape that locks the domain walls in place is an important topological property for antiferromagnetic memory devices in the art, as otherwise the domain walls might spontaneously rearrange such that information in the memory unit is lost rendering robust information storage impossible. Writing of these memory units is done by rotating the Neel vectors of the memory unit, and particularly not by rearranging the domain walls in the memory unit.

A drawback of the antiferromagnetic memory devices in the art is that due to the plurality and stochasticity of Neel vector orientations in each memory unit, memory units cannot be scaled down below certain threshold sizes.

An object of the present invention is to provide an antiferromagnetic memory structure and an antiferromagnetic memory device that improves the existing antiferromagnetic memory devices, particularly such that robust and miniaturized information storing is achieved. The object is achieved by the antiferromagnetic memory structure and the device having the features of claim 1 and 6 respectively, as well as by a method according to claim 15.

Advantageous embodiments are described in the subclaims.

According to claim 1, an antiferromagnetic memory structure is characterized in that the antiferromagnetic memory structure comprises an antiferromagnetic memory body comprising particularly consisting of a particularly monocrystalline antiferromagnetic compound, wherein on a first side, particularly on a first planar surface of the antiferromagnetic memory body, the antiferromagnetic memory body comprises a plurality of separately, particularly disjoint arranged protrusions protruding away from the first side of the antiferromagnetic memory body, wherein the protrusions comprise a memory unit configured to store information, particularly in form of a bit, particularly wherein the protrusions are integrally formed with the antiferromagnetic body, particularly wherein the protrusions consist of the same antiferromagnetic compound.

The antiferromagnetic memory body is solid and might be a planar layer consisting of the antiferromagnetic compound.

Particularly, the antiferromagnetic compound may be a uniaxial antiferromagnetic compound.

The antiferromagnetic memory body extends along a first and a second extension direction and the protrusions face along a third direction that is particularly orthogonal to the first and the second extension direction. In particular, the compound is a uniform compound.

According to an embodiment of the invention, the first extension direction corresponds to an x-axis, the second extension direction corresponds to a y-axis and the antiferromagnetic memory body extends with its protrusions along the z-axis of a Cartesian coordinate system. Particularly, the protrusions are arranged on the first side of the antiferromagnetic memory body along a plane comprising the x- and y-axis, wherein the protrusions protrude along the z-axis away from the first side of the antiferromagnetic memory body.

The antiferromagnetic compound comprises for example Cr₂O₃, CuMnAs, and/or Mn₃Ga. Other antiferromagnetic compounds may comprise Mn2Au, Fe2O3, and/or MnTe.

According to another embodiment of the invention, the antiferromagnetic compound is electrically insulating.

It is noted that the term' protrusion' particularly refers to a protrusion of the antiferromagnetic memory body that comprises a memory unit, such that the protrusion is functionally configured to store information. Particularly, the antiferromagnetic memory body might comprise further protrusions that serve a different purpose, e.g. a mechanical purpose of the antiferromagnetic memory body or a purpose for stabilizing a course of a domain wall and that therefore are not adapted to store information in a memory unit.

According to another embodiment of the invention, the protrusions comprise a stored information in the memory unit.

According to another embodiment of the invention, the protrusions are configured and adapted to store the information, particularly in the memory unit.

According to one embodiment, the antiferromagnetic memory body is monocrystalline or wherein the antiferromagnetic memory body comprises monocrystalline portions, wherein the portions are particularly larger than the protrusions.

According to another embodiment of the invention, each protrusion of the antiferromagnetic memory structure comprises a memory unit.

According to another embodiment of the invention, the antiferromagnetic memory body comprises a plurality of monocrystalline portions that are magnetically coupled, such that the portions do not form an energy barrier that is larger for a domain wall displacement in the antiferromagnetic memory body than an energy barrier for the domain wall formed by the protrusions.

According to an embodiment of the invention, the protrusions on the antiferromagnetic memory body comprise the memory units of the antiferromagnetic memory structure, wherein each memory units serves for storage of information, particularly a single bit.

Particularly, each protrusion comprises only one memory unit. Moreover, the memory unit is integrally formed with the protrusion and consists of the same compound as the protrusion.

According to another embodiment of the invention, each protrusion has a perimeter that circumferentially limits the protrusion. For example, the perimeter may be a portion of the protrusion that is defined by a full width half maximum height of the protrusion, a circumferential portion of the protrusion where the protrusion is elevated more than 2 nm above a the antiferromagnetic memory body, particularly above the first thickness of the antiferromagnetic memory body, and/or by means of a course of a domain wall that extends in an attached fashion along the protrusion, as will be elaborated in a further embodiment of the invention.

According to another embodiment of the invention, the memory unit of each protrusion is located at a central memory portion of the protrusion, particularly wherein the central memory portion is enclosed by the perimeter, more particularly wherein the central memory portion does not comprise the perimeter of the protrusion. Particularly, the central memory portion, (and thus the memory unit) may be arranged away from the perimeter, such that edge effects, such as antiferromagnetic edge effects at the perimeter of the protrusion are not interfering with measurements regarding the memory unit, particularly with measurements determining a Neel state of the memory unit, more particularly, wherein said edge effects are not detected, when determining the Neel state of the memory unit. The central memory portion may comprise up to 90% particularly up to 70% of volume or area comprised by the perimeter of the protrusion.

According to another embodiment of the invention, the memory unit is located within a circumferential, particularly annular portion of the protrusion, wherein the circumferential portion comprises the perimeter of the protrusion.

A portion of a top surface of the protrusion can comprise a surface of the memory unit. According to another embodiment of the invention, the memory units are completely comprised in the protrusions.

The central memory portion and thus the memory unit may comprise contacts for electrical, magnetic and/or electromagnetic read out and writing of a Neel state of the memory unit.

According to another embodiment of the invention, each protrusion forms exactly one memory unit that is configured to store information, particularly wherein each memory unit is configured to store a single bit only.

The protrusions are also referred to as mesas in the context of the current specification.

According to an embodiment of the invention, the protrusions are arranged in a separate disjoint fashion from each other such that a circumferential gap is formed around and between the protrusions.

The structure according to the invention allows for robust, durable, and non-volatile storage of information in the memory units and particularly allows an increased information density to be stored in an antiferromagnetic memory device, as compared to antiferromagnetic memory devices in the art.

Particularly, the protrusions of the antiferromagnetic memory structure form robust memory units for information storage, which provide an alternative information writing mechanism as compared to the devices in the art.

According to another embodiment of the invention, the antiferromagnetic memory structure has been manufactured using a lithography method. Particularly, the protrusions on the first side of the antiferromagnetic memory body are formed by a lithography method.

According to an embodiment of the invention, between the protrusions, the antiferromagnetic memory body has a first thickness and wherein at the protrusions, the antiferromagnetic memory body has a second thickness, such that each protrusion has a height above the first thickness, particularly wherein the heights of the protrusions can differ from each other, particularly wherein the first thickness, the second thickness and/or the heights of the protrusions is in the range of 10 nm to 2.5 mm, particularly in the range of 50 nm to 1 mm, particularly in the range of 100 nm to 0.5 mm, particularly wherein heights are in the range of 35 nm to 5000 nm, particularly in the range of 70 nm to 2000 nm, particularly in the range of 150 nm to 1000 nm.

In general, it is assumed that the higher the protrusions the higher a memory stability of the memory unit is, while on the other hand, writing information may require more energy. Therefore, the person skilled in the art, depending on the specific antiferromagnetic compound and the specification requirements of the antiferromagnetic memory device in which the structure is to be used may chose the first thickness, the second thickness and thus the height of the protrusions accordingly.

Accordingly, the height of the protrusion may be smaller than 10 nm and/or the first thickness may by smaller than 10 nm as well.

According to an embodiment of the invention, the height of the protrusion is larger than 10, particularly larger than 50 atomic layers of the antiferromagnetic compound.

As can be seen the height of the protrusion and the first thickness can adopt a wide range of values.

For example, the antiferromagnetic memory body has a first thickness of 1 mm and the protrusions have a height of 100 nm.

According to an embodiment of the invention, the first thickness of the antiferromagnetic memory body is uniform.

According to an embodiment of the invention, all protrusions have the same height.

The first, the second thickness as well as the height may be measured along the z-axis of the antiferromagnetic memory body.

Particularly the height of the protrusions may be given by the difference between a portion of the protrusion that has the biggest distance along the z-axis to a surrounding portion of the antiferromagnetic memory body having the first thickness.

According to an embodiment of the invention, the protrusions have a first lateral width, such as an outer, an inner diameter or a semi-axis, extending along a first extension direction, such as the x-axis of the antiferromagnetic memory body and a second lateral width, such as an outer, an inner diameter or a semi-axis, extending along a second extension direction of the antiferromagnetic memory body, such as the y-axis, wherein a width of the domain wall is smaller than the first and/or the second lateral width of the protrusions, particularly wherein the first and/or the second lateral width are at least three times larger than the width of the domain wall.

This embodiment allows for an increased stability of information storage in the memory units.

According to an embodiment of the invention, the protrusions have a convex shape, for example wherein the protrusion are drop-shaped, dome-shaped, cuboid, cube-shaped, hemispherical, diamond-shaped, cylindrical, and/or parallelogram-shaped.

Particularly, the perimeter of the protrusion has a circular, oval, or elliptical, a square, rectangular, trapezoid, diamond, a star or a polygon shape.

According to an embodiment of the invention, the perimeter of the protrusions is shaped as a diamond, wherein the half axes of all protrusion are oriented along the x- and y-axis.

According to an embodiment of the invention, the protrusions have a flat top surface.

According to an embodiment of the invention, the protrusions have the same shape, within manufacturing tolerance.

According to an embodiment of the invention, the protrusions have the same height within manufacturing tolerance.

The shape of the protrusion may affect writing properties, such as energy consumption and fidelity for writing, moreover the shape of the protrusions may affect the stability of information storage.

The term 'width of the domain wall' particularly refers to a length scale within which the Neel vector direction changes from its first direction to the second direction, particularly within which the Neel vector rotates 180°. The width of the domain wall particularly depends on the magnetic anisotropy of the antiferromagnetic compound and an exchange stiffness of the antiferromagnetic compound.

According to an embodiment of the invention, a gap width between adjacent protrusions of the protrusions is smaller than 1 µm, particularly smaller than 500 nm, more particularly smaller than 250 nm, more particularly smaller than 100 nm, more particularly smaller than 50 nm, more particularly smaller than 20 nm.

The gap width between the protrusions determines the information density at which protrusions can be arranged, and thus information be stored on the antiferromagnetic memory structure.

Particularly, the gap width is not smaller than a width of a domain wall that may extend between two adjacent protrusions.

The gap width between two protrusions may be measured between the closest points of the perimeters of the two adjacent protrusions. Alternatively, the gap width between two protrusions may be measured at half maximum height of the perimeter of the two protrusions.

If the gap width becomes significantly smaller then then the domain wall width, it may become impossible to write information on each protrusion independently of the adjacent protrusions.

An information density on the antiferromagnetic memory body is also determined by the first and the second lateral width of the protrusions.

According to another embodiment of the invention, a center-to-center distance adjacent protrusions is smaller than 1 µm, particularly smaller than 500 nm, more particularly smaller than 250 nm, more particularly smaller than 100 nm, more particularly smaller than 50 nm, more particularly smaller than 20 nm.

According to another embodiment of the invention, the protrusions are arranged in a regular pattern on the first side of the antiferromagnetic memory body.

A regular pattern may be given by protrusions that are arranged in rows and columns along the first and the second extension direction of the antiferromagnetic memory body.

Moreover, a regular pattern may comprise protrusions that are spaced equidistantly along at least the first and/or the second extension direction from each other or wherein the protrusions are arranged in a repeating pattern.

Particularly, in case the protrusions have a non-isotropic shape in along the first and second extension direction, the protrusions are oriented along the same direction.

This embodiment allows for large scale manufacturing and facile size/capacity scaling of the antiferromagnetic memory devices comprising the antiferromagnetic memory structure.

According to an embodiment of the invention, the antiferromagnetic memory body is formed as a wafer comprising the antiferromagnetic compound, particularly wherein the antiferromagnetic memory body is formed as a layer, particularly a thin film, more particularly wherein the layer is arranged on a substrate, particularly wherein the layer has a first thickness of not more than 200 nm.

The antiferromagnetic compound may be layered on a silicon wafer.

This embodiment allows manufacturing of the antiferromagnetic memory structure for use in memory devices based on a thin film technology, which is widely accessible and established, such that large scale production is possible.

According to an embodiment of the invention, at least 1.000, particularly more than 10⁶ protrusions are arranged on the antiferromagnetic memory body.

According to another aspect of the invention, the invention relates to a non-transitory, particularly non-volatile antiferromagnetic memory device that comprises the antiferromagnetic memory structure for storing information.

It is explicitly noted that aspects of the antiferromagnetic memory devices disclosed in the following are applicable in isolation and/or combination to the antiferromagnetic memory structure as well.

According to an embodiment of the invention, the antiferromagnetic memory body comprises at least one domain wall extending in the antiferromagnetic memory body, wherein the domain wall separates a first region (also referred to as domain) of the antiferromagnetic memory body, in which the antiferromagnetic compound exhibits a first spin structure, where the Neel vector is oriented along a first Neel vector direction, particularly wherein the first Neel vector direction points toward the first side of the antiferromagnetic memory body, and a second region of the antiferromagnetic memory body in which the antiferromagnetic compound exhibits a second spin structure where the Neel vector is oriented along a second Neel vector direction, particularly wherein the second Neel vector direction points in the opposite direction than the first Neel vector direction.

Particularly, the at least one domain wall is present at room temperature. The domain wall extends along the first and/or second direction of the antiferromagnetic memory body.

The direction of the Neel vector may be detected by detecting a surface magnetization of the antiferromagnetic compound, an electric resistance and/or by means of magneto-optical and/or magneto-electric measurements and other techniques such a neutron diffraction and X-ray magnetic dichroism.

The Neel vector is an order parameter for the antiferromagnetic body relating to the spin structure in the antiferromagnetic compound.

This embodiment particularly relates also to only the antiferromagnetic memory structure.

According to an embodiment of the invention, the memory device comprises a read-device that is configured to detect the direction of the Neel-vector of the protrusions, particularly the direction of the Neel vector in the memory units of the protrusions.

Particularly, each protrusion, and thus memory unit has an associated read-device that is configured to detect the Neel state of the associated protrusion, particularly the associated memory unit.

According to an embodiment of the invention, the memory device comprises a magnetic read-device that is configured to detect the direction of the Neel-vector with a magnetic sensor that is configured to detect a local surface magnetization on the first side of the antiferromagnetic memory body, wherein the surface magnetization is oriented along a first or a second magnetization direction, wherein the magnetization direction is indicative of the orientation of the Neel-vector, particularly wherein the second magnetization direction is oriented opposite to the first magnetization direction, more particularly wherein the first magnetization direction corresponds to a magnetic north and the second magnetization direction corresponds to a magnetic south.

Particularly, the magnetic read-device comprises a plurality of magnetic sensors, each configured to detect the local surface magnetization in different portions of the antiferromagnetic memory body.

According to an embodiment of the invention, each protrusion and thus each memory unit has an associated magnetic read-device that is configured to detect the Neel state of the associated protrusion, particularly the memory unit.

According to an embodiment of the invention, the memory device comprises an electric read-device configured to detect the orientation of the Neel-vector with an electric sensor that is configured to detect a local electrical current, voltage and/or a local resistance that is indicative of the orientation of the Neel vector of the antiferromagnetic memory body.

Particularly, the electric read-device comprises a plurality of electric sensors, each configured to detect the local electrical current, voltage and/or a local resistance in different portions of the antiferromagnetic memory body.

According to an embodiment of the invention, each protrusion and thus each memory unit has an associated electric read-device that is configured to detect the Neel state of the associated protrusion, particularly the memory unit.

According to an embodiment of the invention, each memory unit is configured to adopt at least two Neel states, particularly exactly two Neel states only, comprising a first Neel state and a second Neel state, wherein when the memory unit adopts the first Neel state, the memory unit is completely comprised in the first region (as defined by the domain wall) and wherein when the memory unit adopts the second Neel state the memory unit is completely comprised in the second region, particularly wherein the domain wall does not cross the memory unit protrusion when the memory unit is in the first or in the second Neel state, particularly wherein the domain wall extends partially along the perimeter of the protrusion.

It is noted that the domain wall may extend through residual portions of the perimeter of the protrusions, such that strictly speaking the protrusions might not be completely comprised in the first or second region, as the domain wall might 'cut short' on corners of the protrusion. In comparison, the memory unit is defined just such that despite the short cuts of the domain wall at the perimeter of the protrusion that might be present in certain configurations, the memory unit is completely comprised in the first or second region. Particularly for this reason, and for preventing edge effects of the Neel vector at the protrusions, the memory unit is defined for example by means of the central memory portion and/or the course of the domain wall at the perimeter of the protrusion as elaborated previously in the specification.

It is further noted that the term 'domain wall' particularly refers to a functional domain wall, i.e. a domain wall that is configured to render the memory unit either in the first or the second Neel state for example by being moved across the memory unit during a write process. It is particularly well conceivable that residual or non-functional domain walls may be present on the antiferromagnetic memory body that are non-functional in terms of altering the Neel state of the memory units.

This embodiment allows for assigning a bit value to each memory unit. For example, the first Neel state may be associated to a binary 0, wherein the second Neel state may correspond to a binary 1.

The inventors found out that surprisingly, that the domain wall tends to 'stick' to the perimeter of the protrusions, and has a tendency not to cross-through the protrusions/memory unit, but rather extend around the perimeter of the protrusions, as it is energetically more favorable for the domain wall. This phenomenon is also referred to as 'pinning' in the current specification. The inventors are the first to discover this effect and to use this effect for designing an antiferromagnetic memory device.

According to another embodiment of the invention, at least one memory unit of the memory units comprised by the antiferromagnetic memory structure is in the first Neel state and wherein at least one other memory unit of the memory units is in the second Neel state.

According to an embodiment of the invention, the domain wall extends along a first group of protrusions, wherein the domain wall determines the Neel state of each memory unit of the first group of protrusion, particularly by defining whether a memory unit is in the first or in the second region. Particularly, the domain wall does not cross or intersect with itself.

According to an embodiment of the invention, the memory device comprises a plurality of domain walls, and a plurality of groups of protrusions, wherein each domain wall of the plurality of domain walls is associated to one group of protrusions of the plurality of groups of protrusions, particularly such that the course of each domain wall uniquely defines the Neel state of each memory unit of the associated group of protrusions.

Particularly, the groups of protrusions are disjoint groups, i.e. each protrusion belongs to only one group and not two or more groups.

Particularly, each domain wall of the plurality of domain walls is associated to one group of protrusions (and thus memory units) only, and therefore is configured to define the Neel states of the memory units of only one group at a time.

According to another embodiment of the invention, the antiferromagnetic memory body comprises a plurality of first and second regions wherein adjacent to each first region a second region is located in the antiferromagnetic memory body, and wherein adjacent to each second region a first region is located, such that the regions are arranged in an alternating fashion over the antiferromagnetic memory body, wherein one domain wall extends between each first and adjacent second region.

According to another embodiment of the invention, the memory device is configured to adjust, particularly to repeatedly adjust, more particularly to adjust in a controlled fashion, a course of the at least one domain wall in the antiferromagnetic memory body for each protrusion separately, such that the Neel state of the memory unit of the protrusion is adjustable, particularly switchable, between the at least two Neel states, particularly such that the Neel state of the memory unit is adjustable, particularly switchable, from the first to the second Neel state and from the second Neel state to the first Neel state.

This embodiment allows for switching the Neel state of the memory unit of a selected protrusion of the antiferromagnetic memory body such that defined writing of information in a single memory unit is achieved.

The term 'controlled fashion' relates to the property of the device, that the Neel state that is to be assumed by the protrusion is controlled and particularly not depending on a stochastic or less-controlled mechanism.

In contrast to devices known in the art, where the Neel vectors of a memory unit that comprises plurality of granular portions with a plurality of stochastically oriented Neel vectors, are rotated in order to write information to the memory unit, the device according to the invention, writes information in the memory unit by essentially shifting the, particularly a single, domain wall with respect to the protrusion, i.e. the memory unit from a first side of the protrusion to a second side of the protrusion and thereby altering the region in which protrusion is comprised and thus the Neel state of the protrusion.

In particular, the domain walls in the devices known in the art are generally not shifted or moved upon rotation of the Neel vector, while according to the invention, the domain wall is moved across the protrusion, and thus the Neel vector in the memory is reoriented, such that the Neel state of the memory unit is adjusted.

This mechanism has a wide variety of advantages. For example, as elaborated above, the domain wall tends to stick to the perimeter of the protrusions. When switching the Neel state of a protrusion, the domain wall is forced across the protrusion, e.g. by providing an energy to the domain wall to overcome the energetic barrier or by adjusting, i.e. lowering the energetic barrier the protrusion poses to the domain wall. The switching of the domain wall is thus essentially a bi-stable process, with an energy barrier in between that is adjustable for example by easy to control properties such as the geometry, the topology of the protrusions, the properties of the antiferromagnetic compound. Moreover, temporal adjustment may be achieved by dedicated optical, electrical, magnetic, and/or magneto electrical writing devices.

As the switching process of the domain wall is essentially bi-stable, writing of information and also reading of information from a protrusion/memory unit is therefore a well-defined and robust process. In contrast, in the art, the readout result as determined from the 'majority vote' over a plurality of grains / domains of the memory unit that define the logical bit, might be 'close' and as such writing and reading processes are not as well defined as in the device according to the invention. In the device according to the invention, signal strength of an observable indicative of the Neel vector, such as a magnetization, an electric and/or an optical property of the antiferromagnetic compound / protrusion is essentially constant, independent of a fidelity of the switching signal, i.e. there is no 'close' vote that may be caused by a bad or too weak switching signal for the memory unit.

The signal strength provided by the protrusions for example depends on the size, e.g. width and height of the protrusion, a shape of the protrusion and the antiferromagnetic compound used.

Moreover, shifting the at least one domain wall and thereby adjusting the Neel vector orientation of the memory unit is a facile and robust process, as compared to directly rotating the Neel vector of a memory unit in a predefined direction as is done in device known on the art.

According to an embodiment of the invention, the device comprises a Neel state write-device that is adapted and configured to switch the Neel states of the memory units of the protrusions, particularly independently, more particularly repeatedly and in a controlled fashion by adjusting the course of the at least one domain wall in the antiferromagnetic memory body, wherein a memory unit of the memory units of the protrusions that has been selected for switching and that has been completely comprised in the first region before switching, said selected memory unit is completely comprised in the second region after switching and vice versa.

Thus, the write-device allows for writing information in each memory unit separately and independently, particularly not by globally rotating the Neel vector in the memory unit but by transiently shifting the domain wall across the protrusion which Neel state is to be adjusted. Said shifting process is a very short transient process, as the protrusion forms essentially bi-stable energy landscape with un- (or much less) stable intermediate states, that for example would correspond to a domain wall crossing through the protrusion.

In order to prevent any of such intermediate states to become stable or non-transient, the shape of the protrusion may be designed accordingly, e.g. diamond shaped.

The write-device may be one or more of optical, electrical and/or magnetic write devices.

Particularly, the write-device may be a magneto-electrical, or magneto-optical write device.

Particularly, each protrusion has an associated write-device that is configured to adjust the Neel state of the associated memory unit.

According to an embodiment of the invention, the Neel state write-device is configured to electrically adjust the course of the domain wall and thus the Neel states of the memory units, particularly wherein the Neel state write-device comprises at least one electrode configured to adjust the course of the domain wall, particularly wherein the course of the domain wall is adjusted by means of a voltage and/or current signal applied to the protrusion by the write-device, particularly by the at least one electrode.

Such an electric write and/or read-device may comprise at least one first electrical contact, particularly in form of a first contact electrode or layer, wherein the first electrical contact is connected to the antiferromagnetic memory body, particularly on a second side opposite the first side of the antiferromagnetic memory body or on a lateral side of the antiferromagnetic memory body, particularly wherein the at least one first electrical contact is electrically grounded during operation of the device or a floating contact of the device.

According to another embodiment of the invention, the electric write- and/or read-device comprises for each protrusion an electrical contact, particularly in form of a second contact electrode, wherein the second contacts are electrically connected to the associated protrusion, particularly to a top surface of the protrusion, wherein the second electrical contacts are independently controllable, particularly such that a read-current, and/or a switch-voltage or a magneto-electric signal can be applied to the associated protrusion, wherein said switch-voltage is configured to adjust the course of the domain wall, particularly such that the associated memory unit if it has been comprised in the first region, i.e. in the first Neel state before switching is comprised in the second region i.e. in the second Neel state after switching and such that the associated memory unit if it has been comprised in the second region i.e. in the second Neel state before switching is comprised in the first region i.e. in the first Neel state after switching.

Electric and/or magneto-electric switching, i.e. writing, and reading of the Neel state is a robust, cost efficient and reliable way to adjust and to detect the Neel state of the memory unit.

According to another embodiment of the invention, the Neel state write-device is configured to magnetically adjust the course of the domain wall and thus the Neel states of the memory units, particularly wherein the course of the domain wall is adjusted by means of a magnetic signal applied to the protrusion by the write device.

According to another embodiment of the invention, the Neel state write-device is configured to optically adjust the course of the domain wall and thus the Neel states of the memory units, particularly wherein the course of the domain wall is adjusted by means of an optical signal applied to the protrusion by the write device.

According to an embodiment of the invention, the write-device is configured to adjust the course of the domain wall and thus the Neel states of the memory units electrically, optically and/or magnetically, for example, magneto-electrically, or magneto-optically.

According to another embodiment of the invention, the device is configured to detect the Neel state of each memory unit, particularly independently, repeatedly and in a controlled fashion, particularly wherein the Neel state is detected electrically, magnetically and/or magneto-electrically, particularly wherein the device comprises a Neel state read-device that is adapted and configured to detect the Neel state for each memory unit independently, particularly wherein the Neel state read-device comprises a plurality of Neel vector sensors that are associated to the protrusions and that are configured to detect a direction of the Neel vector of the memory unit, wherein each Neel vector sensor is configured and adapted to detect the Neel state, e.g. by means of detecting the direction of the magnetization of its associated protrusion optically, electrically and/or magnetically.

According to a second aspect of the invention, a non-transitory, particularly non-volatile antiferromagnetic memory system is disclosed, wherein the antiferromagnetic memory system comprises an antiferromagnetic memory device according to the invention, a controller for controlling read and write operations of the Neel states of the memory units of the antiferromagnetic memory device, the controller being operationally configured to receive read and write instructions from a processor comprised by the system and to read and to write the Neel state of a selected memory unit of a protrusion in response to the received instructions, particularly wherein the controller is configured to perform read operations of the Neel states of a plurality of memory units in parallel or a sequential fashion and to perform write operations on the Neel states of memory units in parallel or a sequential fashion.

According to a third aspect of the invention, a computer having at least one data memory medium is disclosed, wherein said data memory medium comprises at least one antiferromagnetic memory device according to the invention.

According to a fourth aspect of the invention, a method, particularly a computer-implemented method for operating the antiferromagnetic memory device according to the invention is disclosed, wherein the method comprises the steps of:
a) Preparing the antiferromagnetic memory device such that at least one domain wall extends along particularly the first and/or second extension direction of the antiferromagnetic memory body forming a first region and a second region, such that each memory unit of the protrusions adopts a first or a second Neel state, particularly wherein the domain wall extends partially at the perimeters of the protrusions, particularly not forming completely enclosed closed regions in the antiferromagnetic memory body,
b) Adjusting the Neel state of at least one selected memory unit in a selected protrusion of the protrusions by adjusting the course of the domain wall in the antiferromagnetic memory body, such that the at least one selected memory unit is comprised, particularly completely comprised in the first region, when it has been comprised, particularly completely comprised in the second region before adjusting the course of the domain wall, or such that the at least one selected protrusion is comprised, particularly completely comprised in the second region, when it has been comprised, particularly completely comprised in the first region before adjusting the course of the domain wall, such that the corresponding Neel state is written to the at least one selected memory unit, and/or
c) Reading the Neel state of at least one selected - not necessary the same as in step b) - memory unit of a selected protrusion of the protrusions by determining the Neel state of the at least one selected memory unit, particularly by means of a Neel vector sensor.

The method allows for preparing, i.e. initializing the antiferromagnetic memory device, by generating and/or preparing at the course of at least one, particularly of a plurality of domain walls, particularly wherein the domain walls are prepared such that they do not intersect.

It is noted that steps a), b) and c) may be performed simultaneously. Particularly steps a) and b) may be performed at the same time.

It is noted that step c) may be performed before step b). It is further noted that steps a), b) and c) may be repeatedly executed in varying order.

According to another embodiment of the invention relating to the method, the method comprises the steps of assigning a plurality of groups of protrusions to a plurality of domain walls, wherein each group of protrusion is associated to one domain wall of the domain walls, such that by adjusting the course of the associated domain wall, the Neel state of each memory unit, comprised in the associated group of protrusions is adjustable separately and independently.

With regard to the computer, particularly the computer comprises a computer program, with computer program code that is configured to execute the method according to the invention, when executed on the computer.

For this purpose, the computer, particularly the antiferromagnetic memory device may comprise a Neel state read-device and a Neel state write-device as disclosed in previous embodiments that are operationally controllable by the computer program code and thus the computer.

According to a fifth aspect of the invention, a computer program product is disclosed that is configured to execute the method according to the invention, particularly by operationally controlling the read and the write device of the antiferromagnetic memory device, for example by means of providing control instructions to the controller of the antiferromagnetic memory system.

Terms, features, definitions and embodiments relating to the antiferromagnetic memory structure, the antiferromagnetic memory device according to the invention are applicable in an isolated or combined fashion to the second, the third, the fourth and the fifth aspect of the invention, namely the antiferromagnetic memory system, the computer and the method according to the invention and vice versa.

Particularly, exemplary embodiments are described below in conjunction with the Figures. The Figures are appended to the claims and are accompanied by text explaining individual features of the shown embodiments and aspects of the present invention. Each individual feature shown in the Figures and/or mentioned in said text of the Figures may be incorporated (also in an isolated fashion) into a claim relating to the device according to the present invention.
- Fig. 1A+B: show a schematic view on the antiferromagnetic memory body with a domain wall pinned to a protrusion in a device according to the invention;
- Fig. 2: shows a schematic view of an antiferromagnetic memory device according to the invention with a plurality of memory units being in different Neel states;
- Fig. 3: shows a schematic three-dimensional view similar to Fig. 2.
- Fig. 4: shows differently shaped protrusions of an antiferromagnetic memory structure according to the invention.
- Fig. 5: shows a schematic three-dimensional view of Fig. 4.
- Fig. 6: shows the spin structure in the antiferromagnetic body.
- Fig. 7: shows a system according to the invention; and
- Fig. 8: shows an antiferromagnetic memory unit known in the art.

In the following with reference to the figures an exemplary description of some embodiments of the invention is provided, wherein the reference sings are provided with respect to all figures.

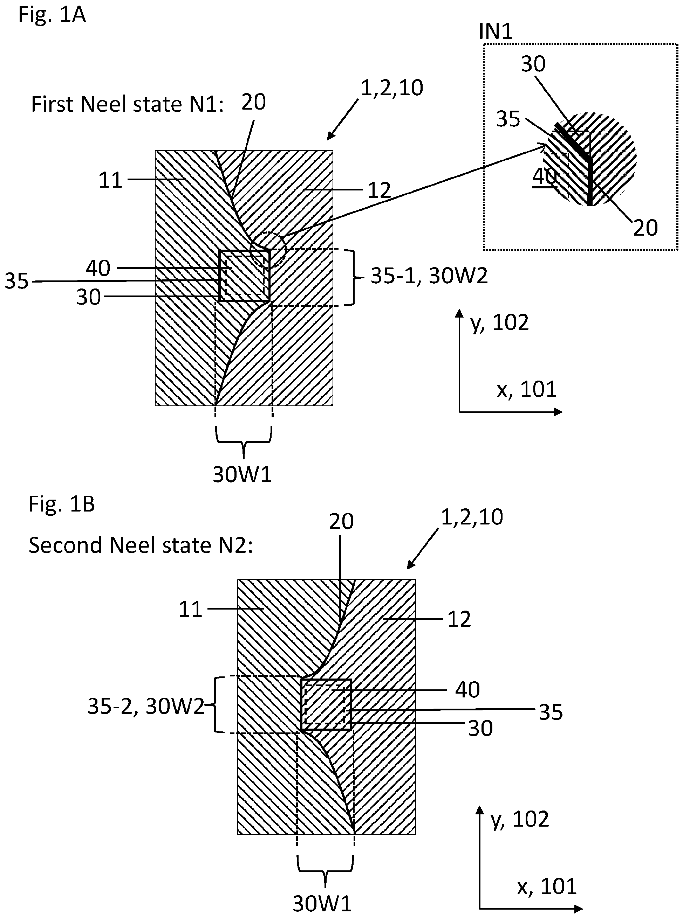

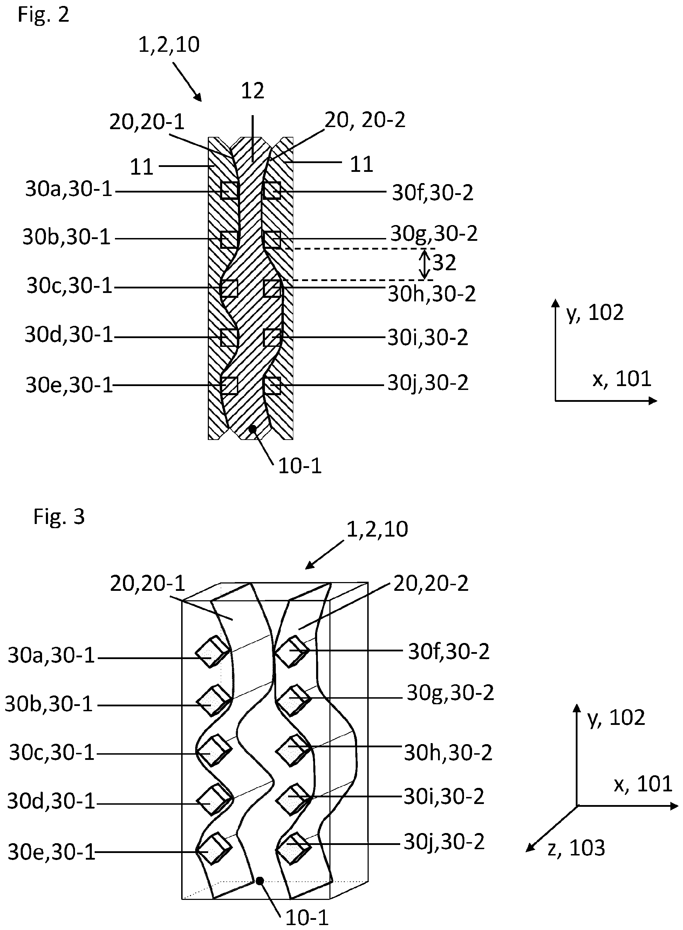

In Figs. 1A, and 1B a schematic view of a portion of a first side of an antiferromagnetic memory body 10 is depicted that is comprised in the antiferromagnetic memory structure 1 of an antiferromagnetic memory device 2. The antiferromagnetic memory body 10 extends along a first and a second extension direction 101, 102, here along the x- and the y- axis of a Cartesian coordinate system. The antiferromagnetic memory body 10 extends also along a third extension direction (cf. Fig. 3, 103, not shown in Fig. 1A and 1B) that is orthogonal to the first and the second extension direction 101, 102. The third extension direction 103 is parallel to a z-axis of the Cartesian coordinate system.

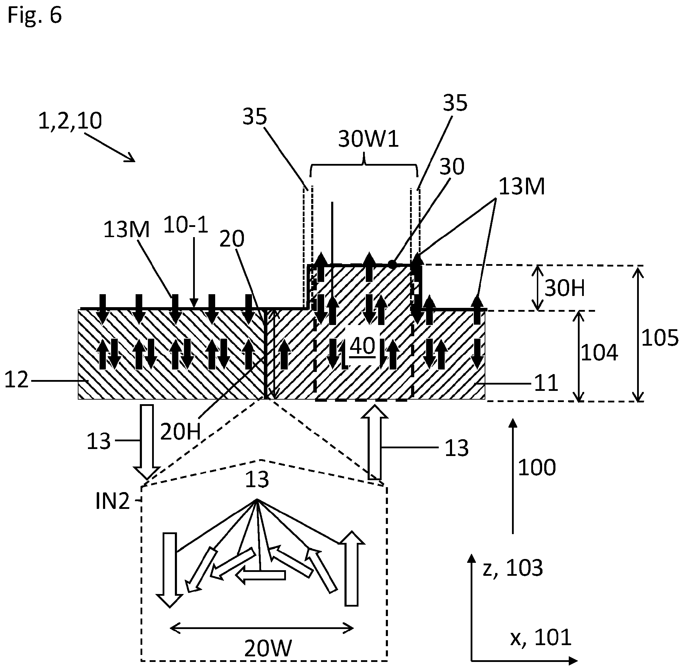

The antiferromagnetic memory body 10 in this example is made of a monocrystalline single crystal uniaxial antiferromagnetic compound, for example (0001)-oriented Cr₂O₃ (cf. Fig. 6).

The antiferromagnetic memory body 10 comprises a domain wall 20, that extends along the antiferromagnetic memory body 10. The domain wall 20 has a width that extends along the plane comprising the x- and the y-axis and a height (not shown in Fig. 1A and 1B) that extends along the third extension direction of the antiferromagnetic memory body 10. The width of the domain wall 20 is typically in the range of several tens of nanometers depending on the antiferromagnetic compound. The height of the domain wall 20 is primarily given by the thickness of the antiferromagnetic memory body 10, i.e. the domain wall typically extends through the antiferromagnetic memory body 10 along the z-axis. The domain wall 20 separates a first region 11 of the antiferromagnetic memory body 10 from a second region 12. The first and the second region 11, 12 differ in their orientation of the associated Neel vector that is representative for the spin structure (cf. Fig. 6) in the antiferromagnetic memory body 10. In the first region 11, the Neel vector (cf. Fig. 6) is oriented along a first direction 100, wherein in the second region 12 the Neel vector 13 is oriented opposite to the first direction 100.

The first and the second region 11, 12 are depicted in Fig. 1A and 1B in terms of differing hatchings.

The direction of the Neel vector 13 may be detected based on magnetic surface stray fields 13M (Fig. 6) on the first side 10-1 of the antiferromagnetic memory body 10, based on an electro-resistivity, magneto-electrically and even optically. Other methods for detecting the orientation of the Neel vector are known, such as X-ray diffraction.

The antiferromagnetic memory body 10 further comprises at least one protrusion 30 (in Fig. 1A and 1B, only one protrusion is shown), but typically a large number of protrusions (30a-30j), e.g. more than 1.000 and even more than 10⁶. Each of the protrusions 30 protrudes away from the first side 10-1 of the antiferromagnetic memory body 10 along the z-axis 103. In the exemplary embodiment shown in Fig. 1A and 1B, the protrusion 30 has a cubic shape. Such a protrusion 30 may be referred to as mesa in the art.

The protrusion 30 is integrally formed with the antiferromagnetic memory body 10 and consists of the same antiferromagnetic compound. Protrusions 30 may be obtained by the use of lithography methods.

The antiferromagnetic memory body 10 therefore has a first essentially constant thickness 104 in portions of the antiferromagnetic memory body 10 where there is no protrusion 30 and a second thickness 105 in the portions of the antiferromagnetic memory body 10 where a protrusion 30 is located. Alternatively or additionally, each protrusion 30 has a height 30H that is measured for example from a portion of the protrusion 30 that has the largest distance along the z-axis 103 to the surface of the antiferromagnetic memory body 10 in portions of the antiferromagnetic memory body 10 where there is no protrusion, i.e. where the antiferromagnetic memory body assumes the first thickness 104.

Further, the protrusion 30 is limited by a circumferential perimeter 35 along the protrusions 30. The perimeter 35 can be defined in various similar ways. For example, the perimeter 35 may be defined in terms of an energy barrier that the perimeter 35 poses to the domain wall 20, or by a percentage of the height of the protrusion 30, i.e. by defining a circumferential region having a predefined elevation above the first thickness 104 of the antiferromagnetic memory body 10.

As can be seen from Fig. 1A, the domain wall 20 follows a course that extends essentially along the y-axis. However, at the protrusion 30, the domain wall 20 bends its course and extends around a first portion 35-1 of the perimeter 35 of the protrusion 30. From visual inspection, it seems as if the domain wall 20 is pinned to the first portion 35-1 of the perimeter 35 of the protrusion 30. Indeed, the protrusion 30 forms an energy barrier that cannot be overcome by the domain wall 20 at room temperature and in the absence of external forces. Therefore, the course of the domain wall 20 adapts such to the energy landscape in the antiferromagnetic memory body 10 that the domain wall 20 does not cross through the protrusion or, if, only at the corners or the periphery of the protrusion (cf. Fig. 1A).

This in turn renders the protrusion 30 essentially completely comprised in the first region 11. For reading and writing purposes the memory unit 40 of comprised in a central memory portion of the protrusion 30, that is far enough away from the perimeter 35 that in any case the domain wall 20 does not touch the memory unit 40, such the memory unit 40 is completely comprised either in the first 11 or in the second region 12 regardless of the corner regions of the protrusion 30 (this is shown in the inset IN1 of Fig. 1). Moreover, the memory unit 40 being comprised in the central portion of the protrusion 30 allows omitting edge effects of the protrusion 40 that might lead to deviating Neel vector 13 orientations.

Particularly, due to the topology of the antiferromagnetic memory body 10, there is no or if, only a much less stable state for the domain wall 20 that would allow the domain wall 20 to extend through the memory unit 40. A second stable state of the domain wall 20 is depicted in Fig. 1B, where the domain wall 20 has been shifted to the second portion 31-2 of the perimeter 31 of the protrusion 30, to which the domain wall 20 is seemingly pinned. In this second stable configuration, the protrusion 30 is essentially completely comprised in the second region 12 of the antiferromagnetic memory body, while the memory unit 40 is with absolute fidelity completely comprised in the second region 12 even at the corners of the protrusion 30.

Because the memory unit 40 is either completely comprised in the first or in the second region 11, 12, the memory unit 40 can serve as a memory storage for storing, reading and writing one bit.

While the memory unit 40 might correspond in large parts and might be completely identical to the protrusion 30, the portion in which the information is stored, safely read and safely written in the protrusion 30 is referred to as the memory unit 40. In contrast to the protrusion 30 in which the memory unit 40 is comprised, for example the memory unit 40 does not comprise the perimeter 35 of the protrusion 30, such that edge effects locally affecting the spin structure and thus the direction of the Neel vector 13 in the protrusion 30 may be excluded during a read processes form the memory device 2. This way, a Neel state N1, N2 of the memory unit 40 can be determined excluding any interference of any edge effects. The memory unit 40 can assume a first Neel state N1 or a second Neel state N2. The memory unit 40 is in the first Neel state N1, when the memory unit 40 is completely comprised in the first region 11 and the memory unit is in the second Neel state N2, when the memory unit 40 is completely comprised in the second region 12. In contrast, the protrusion 30 comprising the memory unit 40 might not completely be comprised in the first or second region 11, 12as the domain wall might cut short at some portion of the perimeter of the protrusion (cf. Fig. 1, inset IN1).

Thus, the protrusion and the memory unit 30, 40 allows for storing information by way of the orientation of the Neel vector 13 in the area/volume of the memory unit 40. As the Neel vector 13 may be oriented along two directions, each memory unit 40 can store a single bit value, for example indicative of a binary 0 or a binary 1.

It is noted that for determining the Neel state N1, N2 of the memory unit 40, it the direction of the Neel vector 40 is determined for the in the central memory portion of the protrusion 30 depicted as a boxed region with broken lines in order to avoid edge effects at the perimeter of the protrusion. The boxed region therefore corresponds to the memory unit 40.

In order to read stored information from a selected memory unit 40, the Neel state N1, N2 of the memory unit 40 is determined. In order to write an information to a selected memory unit 40, the domain wall 20 is shifted transiently across the protrusion 30 and the memory unit 40, such that the memory unit 40 is comprised in the respective other region 12, 11 after shifting. Shifting the domain wall 20 can be done electrically, magnetically, magneto-electrically and/or optically. For example, it is possible to shift the domain wall 20 by means of laser dragging.

The antiferromagnetic memory body 10 comprising the protrusions 30 allows for memory units 40 that adopt a well-defined and robust first and second Neel state N1, N2. Writing of information is robust and relies on the adjustment of the course of the domain wall 20 rather than on rotating the Neel vector directly in the memory units while the domain walls may stay in place as done in devices known in the art.

Fig. 2 schematically depicts a portion of the first surface 10-1 of the antiferromagnetic memory body 10 of an antiferromagnetic memory device 2. This example illustrates an embodiment of the memory device 2 according to the invention having at least two domain walls 20-1, 20-2 and a plurality of protrusions 30a to 30j, each comprising a memory unit (not shown). Definitions and reference signs apply from Fig. 1A and 1B in analogous fashion and are not reiterated for sake of conciseness.

Each protrusion 30a to 30b is separated by a gap width 32 from a neighboring protrusion. Therefore, each protrusion is spatially separated from each other, which allows separate adjustment of the Neel state of each memory unit of the protrusion.

The gap width 32 is at least as wide as the width of the domain wall 20W (cf. Fig. 6), such that the domain wall 20 can cross between two adjacent protrusions, e.g. 30b and 30c.

The first domain wall 20-1 is associated to a first group 30-1 of protrusions 30 (30a to 30e) and is configured to adjust the Neel states of the memory units 40 comprised in the first group 30-1 only. A second domain wall 20-2 is associated to a second group 30-2 of protrusions 30 (30f to 30j), and is configured to adjust the Neel states of the memory units comprised in the second group 30-2 only. As can be seen, the memory units belong either to the first or the second group.

The two groups of protrusions 30-1, 30-2 each extends in a row along the y-axis of the antiferromagnetic memory body 10, forming a regular pattern of protrusions in form of a matrix having two rows and two columns. The first and the second domain wall 20-1, 20-2 extend essentially along the y-axis, while meandering along the first or the second portions of the perimeter of the protrusions. The antiferromagnetic memory body 10 is alternatingly separated in a first 11 and an adjacent second region 12 along the x-axis by the domain walls 20-1, 20-2. In case there would be a third domain wall (and a third group of protrusions), a further second region would be formed.

The first domain wall 20-1 separates the antiferromagnetic memory body 10 in the first 11 and the second region 12, rendering some of the associated memory units (30a, 30b, 30d) of the first group 30-1 in the first Neel state N1, while other memory units (30c, 30e) from the first group 30-1 remain in the second Neel state N2. In a similar fashion, the second domain wall 20-2 extends along the row comprising the second group 30-2 of memory units 30. The second domain wall 20-2 separates the antiferromagnetic memory body 10 in the second region 12 and in an additional first region 11, wherein the second region 12 corresponds to the second region 12 that defined by the first domain wall 20-2.

The meandering course of the second domain wall 20-2 renders some of the memory units (30h, 30i) of the second group 30-2 in the second Neel state N2, as they are comprised in the second region 12, and the remaining memory units (30f, 30g, 30j) of the second group 30-2 in the first Neel state N1, as they are comprised in the additional first region 11. The spin structure of the additional first region is identical to the spin structure of the first region.

By adjusting the course of the first domain wall 20-1 with respect to the perimeters of the protrusions 30 comprised in the first group 30-1, the Neel state of a single memory unit in the first group 30-1 may be altered. Similarly, the Neel state of any of the memory units comprised in the second group 30-2 of protrusions may be altered by adjusting the course of the second domain wall 20-2. Altering the Neel states of the first group 30-1 does not affect the Neel states of the second group 30-2, and vice versa.

In Fig. 3 a three-dimensional representation of the antiferromagnetic memory body 10 of Fig. 2 is shown, with the difference that the protrusions 30 are diamond shaped. It can be seen that the protrusions 30 that comprise the memory units protrude along the z-axis away from the first side 10-1 of the antiferromagnetic memory body 10. The first and the second domain wall 20-1, 20-2 extend with a height along the z-axis through the antiferromagnetic memory body 10.

The diamond-shape of the protrusions 30 increases the robustness against formation of unwanted metastable intermediate states of the domain wall 20 through the protrusions 30, when the Neel state of a memory unit is to be switched.

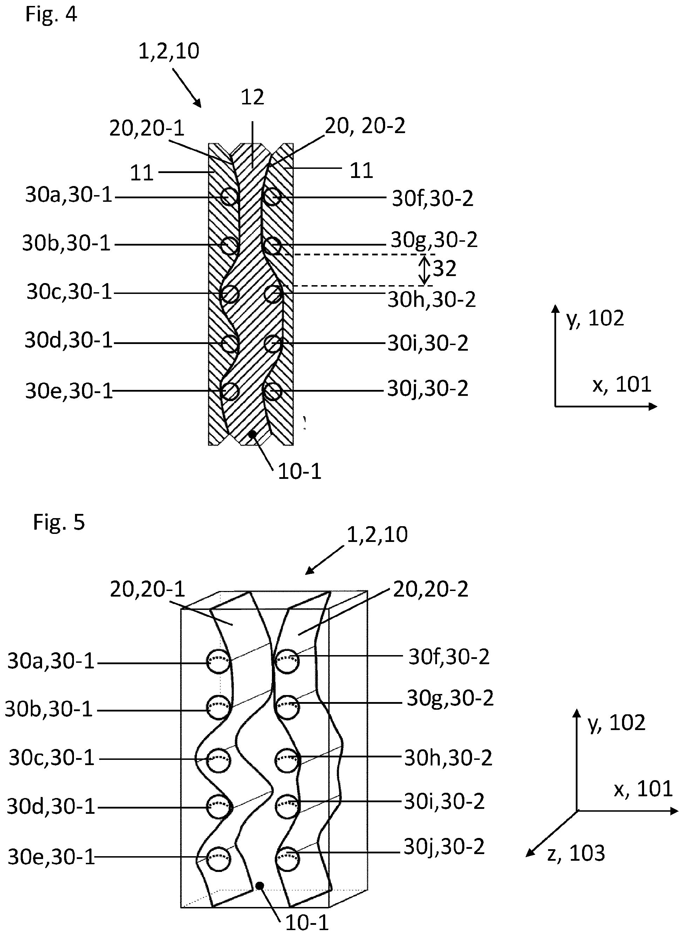

Fig. 4 and Fig. 5 show slight variations of the memory structure 1 and device 2 according to the invention as shown in Fig. 2 and Fig. 3. Other than in Fig. 2 and Fig. 3, the protrusions 30 of the antiferromagnetic memory body 10 have a hemispherical shape, with a circular cross-section in the plane comprising the x- and y-axis.

The shape of the protrusions 30 may affect the switching behavior of the protrusions 30.

Not shown are the Neel state read-device as well as the Nee state write device, due to the variety of possible implementation schemes, that facilitate the desired reading and writing processes for individual memory units. It is noted that any Neel-state write-device is configured to adjust the course of the domain wall of the associated protrusion from the first portion of the perimeter to the second portion of the perimeter of the protrusion. This local shifting of the domain wall causes a reorientation of the Neel vector of the associated memory unit. This mechanism of altering the Neel state of a memory unit is in contrast to device known in the art, where by means of an external signal, such as a voltage signal, the average orientation of the Neel vector for a memory unit is rotated, while the domain walls comprised in a memory unit remain at stationary.

Fig. 6 shows a schematic cross-section through the antiferromagnetic memory body 10 along the x, z plane. In black full arrows the spin structure is depicted.

It can be seen that the spins are oriented pairwise antiparallel such that no net magnetization is exhibited by the antiferromagnetic memory body. However, on the surface 10-1, a magnetic stray filed 13M is observable that changes its direction as a function of the Neel vector 13 direction.

In the first region 11 of the antiferromagnetic memory body 10, the Neel vector 13 is oriented along a first direction 100 that is in this example parallel to the z-axis. In the second region 12, the Neel vector is oriented antiparallel to the first direction 100, which gives rise to the magnetic stray field 13M being oriented in in the opposite direction (as compared to the magnetic field direction in the first region) as well. Thus, the direction of the Neel vector may be determined by measuring the surface magnetization of the antiferromagnetic memory body 10.

The first and the second region 11, 12 re separated by the domain wall 20 having a domain wall height 20H extending along the z-axis.

Fig. 6 exemplarily shows one protrusion 30 comprising a memory unit 40. The protrusion has a protrusion height 30H that may be measured as the difference form the second thickness 105 of the antiferromagnetic memory body 10 and the first thickness 104 of the antiferromagnetic memory body 10. With regard to the other reference signs and features it is referred to the previous figures. An enlarged view of the domain wall 20 is shown in inset IN2. Here it can be seen that over the width 20W of the domain wall 20 the Neel vector 13 changes its orientation. The width 20W of the domain wall 20 may be indeed defined by the length required for the Neel vector to rotate 180°, which is typically in the range of a few nanometers only.

An exemplary test sample may be obtained and formed as follows:
The antiferromagnetic memory body is a (0001)-oriented Cr₂O₃ single-crystal, that has a first thickness of 1 mm, with millimeter-scale lateral dimensions along the first and second extension direction. A patterned a grid of micron-scale cuboid mesas (protrusions) with mean height t = 166 nm ± 4 nm and width w = (2.4 ± 0.3) µm on the first side of the antiferromagnetic memory body is obtained using standard lithography. To induce magnetic domains, i.e. first and second regions in the Cr₂O₃ antiferromagnetic memory body, magneto-electric field cooling across T_{Neel} (Neel temperature) is employed. Specifically, collinear electric and magnetic bias fields along the surface normal with B_{bias} = 550 mT and E_{bias} = ±0.75 MV/m may be used, where a split-gate capacitor was used to invert E_{bias} between the two regions of the antiferromagnetic memory body.

The local Neel vector orientation may be read by means of a nitrogen vacancy (NV) magnetometry at room temperature.

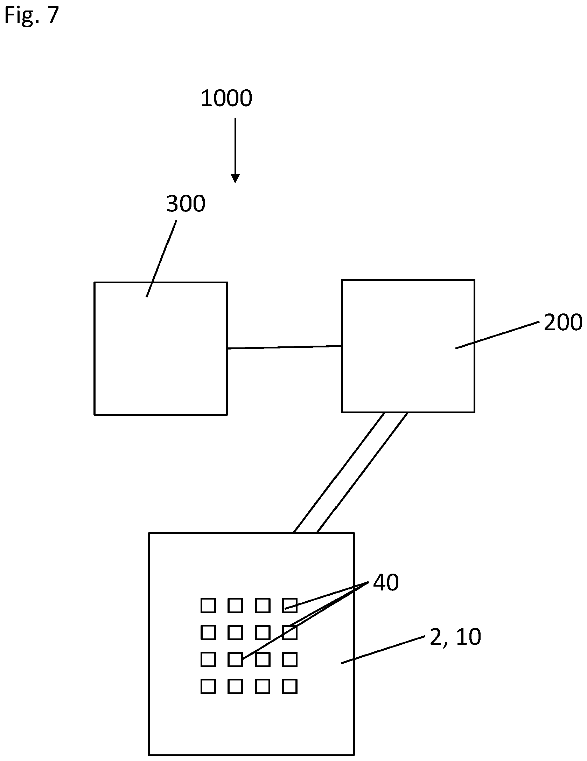

In Fig. 7 a schematic drawing representing an antiferromagnetic memory system 1000 is shown. The system 1000 comprises the antiferromagnetic memory device 2, a controller 200 for controlling the read and write operations for the memory units 40 by means of adjusting the course of the domain wall(s) through the antiferromagnetic memory body 10 as well as a processor 300 or a computer, that is configured to issue instructions to the controller 200 as to which memory units 40 to write and/or read.

Fig. 8A and 8B show an antiferromagnetic memory body known in the art that comprising plurality of domain walls forming and enclosing monocrystalline cells, each giving rise to a different orientation of the Neel vector. The memory units are not comprised in a protrusion but are integrally formed with a planar and even antiferromagnetic memory body. Fig. 8A shows a view on the first side of the antiferromagnetic memory body, wherein Fig. 8B depicts a cross-section along the x-z axis of the antiferromagnetic memory body.

## Claims

1. An antiferromagnetic memory structure (1) configured for use in a non-transitory antiferromagnetic memory device (2), **characterized in that** the antiferromagnetic memory structure (1) comprises an antiferromagnetic memory body (10) comprising an antiferromagnetic compound, wherein on a first side (10-1) of the antiferromagnetic memory body (10), the antiferromagnetic memory body (10) comprises a plurality of separately arranged protrusions (30, 30-1, 30-2) protruding away from the first side (10-1) of the antiferromagnetic memory body (10), wherein the protrusions (30) comprise a memory unit (40) configured to store information.

2. The antiferromagnetic memory structure (1) according to claim 1, wherein between the protrusions (30), the antiferromagnetic memory body (10) has a first thickness (104) and wherein at the protrusions (30), the antiferromagnetic memory body (10) has a second thickness (105), such that each protrusion (30) has a height (30H) above the first thickness (104), particularly wherein the first thickness (104), the second thickness (105) and/or the heights (30H) of the protrusions (30) is in the range of 10 nm to 2.5 mm, particularly in the range of 50 nm to 1 mm, particularly in the range of 100 nm to 0.5 mm, particularly wherein the heights are in the range of 35 nm to 5000 nm, particularly in the range of 70 nm to 2000 nm, particularly in the range of 150 nm to 1000 nm.

3. The antiferromagnetic memory structure (1) according to any of the preceding claims, wherein a gap width (32) between adjacent protrusions (30) is smaller than 1 µm, particularly smaller than 500 nm, more particularly smaller than 250 nm, more particularly smaller than 100 nm, more particularly smaller than 50 nm, more particularly smaller than 20 nm.

4. The antiferromagnetic memory structure (1) according to any of the preceding claims, wherein the protrusions (30) are arranged in a regular pattern on the first side (10-1) of the antiferromagnetic memory body (10).

5. The antiferromagnetic memory structure (1) according to any of the preceding claims, wherein the antiferromagnetic memory body (10) is formed as a wafer comprising the antiferromagnetic compound, particularly wherein the antiferromagnetic memory body (10) is formed as a layer, particularly a thin film, more particularly wherein the layer is arranged on a substrate, particularly wherein the layer has a first thickness (104) of not more than 200 nm.

6. A non-transitory antiferromagnetic memory device (2) comprising the antiferromagnetic memory structure (1) according to any of the preceding claims.

7. The device (2) according to claim 6, wherein the antiferromagnetic memory body (10) comprises at least one domain wall (20, 20-1, 20-2) extending in the antiferromagnetic memory body (10), wherein the at least one domain wall (20) separates a first region (11) of the antiferromagnetic memory body (10), in which the antiferromagnetic compound exhibits a first spin structure, where the Neel vector (13) is oriented along a first Neel vector direction (100), and a second region (12) of the antiferromagnetic memory body (10) in which the antiferromagnetic compound exhibits a second spin structure where the Neel vector (13) is oriented along a second Neel vector direction, particularly wherein the second Neel vector direction points in the opposite direction than the first Neel vector direction (10).

8. The device (2) according to claim 7, wherein each memory unit (40) is configured to adopt at least two Neel states, comprising a first Neel state (N1) and a second Neel state (N2), wherein in the first Neel state (N1), the memory unit(40) is completely comprised in the first region (11) and wherein in the second Neel state (N2), the memory unit (40) is completely comprised in the second region (12).

9. The device (2) according to claim 8, the antiferromagnetic memory device (2) is configured to adjust a course of the at least one domain wall (20) in the antiferromagnetic memory body (10) for each protrusion (30) separately, such that the Neel state (N1, N2) of the memory unit (40) of the protrusion (30) is adjustable between the at least two Neel states (N1, N2).

10. The device (2) according to any of the claim 9, wherein the antiferromagnetic memory device (2) comprises a Neel state write-device that is adapted and configured to switch the Neel states of the memory units (40 of the protrusions (30) by adjusting the course of the at least one domain wall (20) in the antiferromagnetic memory body (10), wherein a memory unit (40) of the memory units (40) of the protrusions (30) that has been selected for switching and that has been completely comprised in the first region (11) before switching, said selected memory unit is completely comprised in the second region (12) after switching and vice versa.

11. The device (2) according to claim 10, wherein the Neel state write-device is configured to electrically adjust the course of the domain wall (20), particularly wherein the Neel state write-device comprises at least one electrode for adjusting the course of the domain wall (20), particularly wherein the course of the domain wall (20) is adjusted by means of a voltage and/or a current signal applied to the protrusion (30) by the write-device.

12. The device (2) according to claim 10 or 11, wherein the Neel state write-device is configured to magnetically and/or magneto-electrically adjust the course of the domain wall (20), particularly wherein the course of the domain wall (20) is adjusted by means of a magnetic and/or an magneto-electric signal applied to the protrusion (30) by the write device.

13. The device (2) according to any of the claims 10 to 12, wherein the device (2) is configured to detect the Neel state (N1, N2) of each memory unit (40), wherein the Neel state (N1, N2) is detected electrically, magnetically and/or magneto-electrically.

14. A non-transitory antiferromagnetic memory system (1000) comprising the antiferromagnetic memory structure (1) according to any of the claims 1 to 5 and/or the antiferromagnetic memory device (2) according to any of the claims 6 to 13, wherein the antiferromagnetic memory system (1000) further comprises a controller (200) configured and adapted to control read and write operations of the Neel states (N1, N2) of the memory units (40) of the antiferromagnetic memory device (2), the controller (200) being operationally configured to receive read and write instructions from a processor (300) comprised by the system (1000)and to read and to write the Neel state (N1, N2) of a memory unit (40) of the protrusions in response to the received instructions.

15. A method for operating the antiferromagnetic memory device (2) or system (1000) according to any of the claims 6 to 14, wherein the method comprises the steps of:
a) Preparing the antiferromagnetic memory device (2) such that at least one domain wall (20, 20-1, 20-2) extends along the antiferromagnetic memory body (10) forming a first region (11) and a second region (12), such that each memory unit (40) adopts the first or the second Neel state (N1, N2),
b) Adjusting the Neel state (N1, N2) of at least one selected memory unit by adjusting the course of the domain wall (20, 20-1, 20-2) in the antiferromagnetic memory body (10), such that the at least one selected memory unit (40) is comprised in the first region (11) , when it has been comprised in the second region (12) before adjusting the course of the domain wall (20), or such that the at least one selected memory unit (40) is comprised in the second region (12), when it has been comprised in the first region (11) before adjusting the course of the domain wall (20), and/or
c) Reading the Neel state (N1, N2) of at least one selected memory unit (40) by determining the Neel state (N1, N2) of the at least one selected memory unit (40).
